(19)

Europäisches
Patentamt
European
Patent Office
Office européen
des brevets

(11) **EP 4 481 888 A2**

(12) **EUROPEAN PATENT APPLICATION**

(43) Date of publication:
**25.12.2024 Bulletin 2024/52**

(21) Application number: **24182025.7**

(22) Date of filing: **13.06.2024**

(51) International Patent Classification (IPC):
**H01M 10/42** (2006.01)    **H01M 10/48** (2006.01)
**H01M 4/587** (2010.01)    **H01M 10/0525** (2010.01)

(52) Cooperative Patent Classification (CPC):
**H01M 10/48**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.06.2023  JP 2023097729**

(71) Applicant: **TOYOTA JIDOSHA KABUSHIKI
KAISHA
Aichi-ken, 471-8571 (JP)**

(72) Inventors:
• **FUJIWARA, Mai
Toyota-shi, 471-8571 (JP)**
• **NISHI, Yuji
Toyota-shi, 471-8571 (JP)**
• **KONDO, Hiroki
Nagakute-shi 480-1192 (JP)**
• **SASAKI, Tsuyoshi
Nagakute-shi 480-1192 (JP)**

(74) Representative: **D Young & Co LLP
3 Noble Street
London EC2V 7BQ (GB)**

(54) **METHOD OF MANAGING LITHIUM ION SECONDARY BATTERY AND BATTERY
MANAGEMENT SYSTEM**

(57)    A method of managing a lithium ion secondary battery is to manage a battery (10) as a lithium ion secondary battery including a negative electrode (2) containing a graphite-based negative electrode active material and a negative electrode current collector (21). A battery model is a multi-particle model representing the negative electrode active material by a plurality of types of particles that each indicate a likelihood of occurrence of a charge transfer reaction of lithium ions, and at least one of a structure parameter and a material property parameter is different among the plurality of types of particles. The method includes: for each of target particles, calculating a lithium amount based on a reaction current density; and calculating, as an SOC of the battery (10), an average value of the lithium amount in each of the plurality of types of particles.

FIG.7

```
                    START
                      │
                      ▼
        ┌──────────────────────────────────┐  S101
        │ ACQUIRE/READ NECESSARY PARAMETER │
        │ FROM SENSOR/MEMORY               │
        └──────────────────────────────────┘
                      │
                      ▼
        ┌──────────────────────────────────┐  S102
        │ CALCULATE REACTION OVERVOLTAGE ηⱼ│
        │ FOR EACH PARTICLE BASED ON       │
        │ NEGATIVE ELECTRODE OPEN-CIRCUIT  │
        │ POTENTIAL Uⱼ                     │
        └──────────────────────────────────┘
                      │
                      ▼
        ┌──────────────────────────────────┐  S103
        │ CALCULATE REACTION CURRENT       │
        │ DENSITY iⱼ FOR EACH PARTICLE     │
        │ BASED ON ηⱼ                      │
        └──────────────────────────────────┘
                      │
                      ▼
        ┌──────────────────────────────────┐  S104
        │ CALCULATE CURRENT Iⱼ FLOWING     │
        │ THROUGH EACH PARTICLE            │
        └──────────────────────────────────┘
                      │
                      ▼
        ┌──────────────────────────────────┐  S105
        │ CALCULATE TOTAL CURRENT I FROM   │
        │ TOTAL SUM OF Iⱼ                  │
        └──────────────────────────────────┘
                      │
                      ▼
        ┌──────────────────────────────────┐  S106
        │ CALCULATE LITHIUM AMOUNT θⱼ FOR  │
        │ EACH PARTICLE                    │
        └──────────────────────────────────┘
                      │
                      ▼
        ┌──────────────────────────────────┐  S107
        │ CALCULATE AVERAGE VALUE OF θⱼ    │
        │ AS SOC                           │
        └──────────────────────────────────┘
                      │
                      ▼                       S108
        ◁ HAS PROCESS FOR ALL ▷── NO
          CELLS BEEN COMPLETED ?
                      │ YES
                      ▼
                     END
```

The flow diagram (FIG.7) contains the following steps:

- **S101**: ACQUIRE/READ NECESSARY PARAMETER FROM SENSOR/MEMORY
- **S102**: CALCULATE REACTION OVERVOLTAGE $\eta_j$ FOR EACH PARTICLE BASED ON NEGATIVE ELECTRODE OPEN-CIRCUIT POTENTIAL $U_j$
- **S103**: CALCULATE REACTION CURRENT DENSITY $i_j$ FOR EACH PARTICLE BASED ON $\eta_j$
- **S104**: CALCULATE CURRENT $I_j$ FLOWING THROUGH EACH PARTICLE
- **S105**: CALCULATE TOTAL CURRENT I FROM TOTAL SUM OF $I_j$
- **S106**: CALCULATE LITHIUM AMOUNT $\theta_j$ FOR EACH PARTICLE
- **S107**: CALCULATE AVERAGE VALUE OF $\theta_j$ AS SOC
- **S108**: HAS PROCESS FOR ALL CELLS BEEN COMPLETED? (NO → loop back; YES → END)

**EP 4 481 888 A2**

**Description**

CROSS REFERENCE TO RELATED APPLICATIONS

This nonprovisional application is based on Japanese Patent Application No. 2023-097729 filed on June 14, 2023 with the Japan Patent Office, the entire contents of which are hereby incorporated by reference.

BACKGROUND

Field

The present disclosure relates to a method of managing a lithium ion secondary battery and a battery management system, and more particularly to a technique for estimating a state of charge (SOC) of a lithium ion secondary battery.

Description of the Background Art

Japanese Patent Laying-Open No. 2008-243373 discloses a device which estimates the internal state of a secondary battery based on a battery model.

SUMMARY

Highly accurate estimation of the state of charge (SOC) of a lithium ion secondary battery has always been demanded. For example, it is desirable to refine a battery model as disclosed in Japanese Patent Laying-Open No. 2008-243373 to thereby improve the accuracy in estimating the SOC of a lithium ion secondary battery. The present inventors have focused their attention on the fact that, particularly when a negative electrode of a lithium ion secondary battery contains a graphite-based negative electrode active material, it is not easy to highly accurately estimate the SOC using a battery model.

The present disclosure has been made in order to solve the above-described problem, and an object of the present disclosure is to highly accurately estimate an SOC of a lithium ion secondary battery including a negative electrode containing a graphite-based negative electrode active material.

(1) A method of managing a lithium ion secondary battery according to an aspect of the present disclosure is to manage a lithium ion secondary battery including a negative electrode. The negative electrode contains a negative electrode active material based on graphite and a negative electrode current collector. The method includes, estimating, by a processor, an SOC of the lithium ion secondary battery using a battery model for estimating an internal state of the lithium ion secondary battery. The battery model is a multi-particle model representing the negative electrode active material by a plurality of types of particles, each of the plurality of types of particles represents a likelihood of occurrence of a charge transfer reaction of lithium ions, and at least one of a structure parameter and a material property parameter is different among the plurality of types of particles. The structure parameter includes at least one of: a particle diameter of the negative electrode active material; a distance between the negative electrode active material and the negative electrode current collector; a thickness of the negative electrode; a density of a particle of the negative electrode active material; a frequency distribution of the particle diameter of the negative electrode active material; and a distribution of a conductive auxiliary agent contained in the negative electrode. The material property parameter includes a resistivity of a material of each of the negative electrode active material and the negative electrode current collector. The estimating the SOC includes first to fourth steps. The first step is a step of calculating, for each of target particles among the plurality of types of particles, a reaction overvoltage based on a previous value of a lithium amount contained in each of the target particles. The second step is a step of calculating, for each of the target particles, a reaction current density of each of the target particles based on the reaction overvoltage. The third step is a step of, calculating, for each of the target particles, a present value of the lithium amount based on the reaction current density. The fourth step is a step of calculating an average value of the present value of the lithium amount in each of the plurality of types of particles as the SOC of the lithium ion secondary battery.

Although details will be described later, when the negative electrode of the lithium ion secondary battery contains a graphite-based negative electrode active material, an SOC-OCV curve appears as a gradient change resulting from the stage structure of graphite. This gradient change varies depending on how the lithium ion secondary battery is charged and discharged (a start SOC and a current rate, which will be described later). It was difficult to reproduce such a SOC-OCV curve in a conventional battery model. On the other hand, according to the method in the above (1), in the SOC-OCV curve, the gradient change resulting from the stage structure of graphite can be faithfully reproduced as an actual gradient change. Therefore, the SOC of the lithium ion secondary battery including a negative electrode containing a graphite-based negative electrode active material can be estimated with high accuracy.

(2) The calculating the lithium amount includes calculating, for each of the target particles, a change over time in the lithium amount resulting from solid-phase diffusion of the lithium ions. (3) The solid-phase diffusion is represented by a relational expression indicating a behavior of a first-order lag and having a time constant corresponding to a diffusion rate of the lithium ions.

According to the method in the above (2) and (3), the positional deviation of the gradient change (the shift of the SOC-OCV curve in the SOC direction) can be more faithfully reproduced by considering the solid-phase diffusion. Therefore, the accuracy in estimating the SOC of the lithium ion secondary battery can be further improved.

(4) In the battery model, the particles are reduced to be smaller in number by setting weighting for each the structure parameter or each the material property parameter represented by each of the target particles, than when the weighting is not set.

According to the method in the above (4), when weighting is set for each the structure parameter or each the material property parameter, the particles are reduced in number as compared with the case where all of the particles are assumed to have different structure parameters or different material property parameters. Therefore, the computation load of the processor can be reduced.

(5) The lithium ion secondary battery includes a positive electrode containing a positive electrode active material. A flat region of the positive electrode active material is wide, the flat region being a region in which a potential change resulting from an SOC change is minute. (6) The positive electrode active material contains lithium iron phosphate.

In the case of the positive electrode active material such as lithium iron phosphate, the SOC region has a wide flat region, and thus, the gradient change resulting from the stage structure of graphite exerts a significantly influence. In other words, the accuracy in estimating the SOC tends to decrease. Thus, according to the methods in the above (5) and (6), since the method of managing the lithium ion secondary battery according to the present disclosure is applied to such a positive electrode active material, an effect of enabling highly accurate estimation of the SOC is particularly remarkably achieved.

(7) A battery management system according to another aspect of the present disclosure includes the processor.

According to the configuration in the above (7), the SOC of the lithium ion secondary battery including a negative electrode containing a graphite-based negative electrode active material can be estimated with high accuracy, as with the method in the above (1).

The foregoing and other objects, features, aspects, and advantages of the present disclosure will become apparent from the following detailed description of the present disclosure, which is understood in conjunction with the accompanying drawings.

BRIEF DESCRIPTION OF THE DRAWINGS

Fig. 1 is a diagram schematically showing an overall configuration of a vehicle equipped with a battery management system according to an embodiment of the present disclosure.
Fig. 2 is a perspective view schematically showing an example of a configuration of a cell.
Fig. 3 is a diagram showing an example of a configuration of an electrode assembly.
Fig. 4 is a conceptual diagram for illustrating a multi-particle model.
Fig. 5 is a conceptual diagram for illustrating a plurality of particles included in the multi-particle model.
Fig. 6 is a diagram for illustrating an outline of a relation between parameters in the multi-particle model.
Fig. 7 is a flowchart illustrating a processing procedure of an SOC estimation process in the present embodiment.
Fig. 8 is a diagram showing an example of a lithium amount-negative electrode OCP curve.
Fig. 9 is a diagram for illustrating a stage structure of graphite.
Fig. 10 is a diagram showing an example of an SOC-OCV curve.

DESCRIPTION OF THE PREFERRED EMBODIMENTS

The following describes an embodiment of the present disclosure in detail with reference to the accompanying drawings. In the accompanying drawings, the same or corresponding portions are denoted by the same reference characters, and the description thereof will not be repeated.

The following describes an example of a configuration in which a battery management system (BMS) according to the present disclosure is mounted in a battery electric vehicle (BEV). However, the battery management system according to the present embodiment is applicable to all types of vehicles on which a lithium ion secondary battery for traveling is mounted. In other words, the battery management system according to the present disclosure that may be mounted in a hybrid electric vehicle (HEV), a plug-in hybrid electric vehicle (PHEV), a fuel cell electric vehicle (FCEV), and the like. The battery management system according to the present disclosure is not necessarily applied only for a vehicle but may be applied also for stationary use.

[Embodiments]

<Overall Configuration>

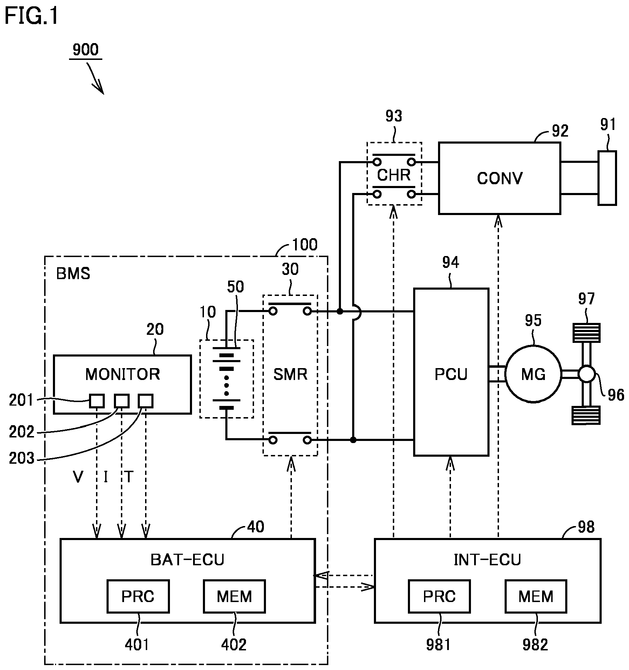

Fig. 1 is a diagram schematically showing an overall configuration of a vehicle equipped with a battery management system according to an embodiment of the present disclosure. A vehicle 900 includes a battery management system 100. Battery management system 100 is a battery pack and includes a battery 10, a monitoring unit 20, a system main relay (SMR) 30, and a battery electronic control unit (ECU) 40. Vehicle 900 further includes an inlet 91, a power conversion device 92, a charging relay 93, a power control unit (PCU) 94, a motor generator (MG) 95, a power transmission gear 96, a driving wheel 97, and an integrated ECU 98.

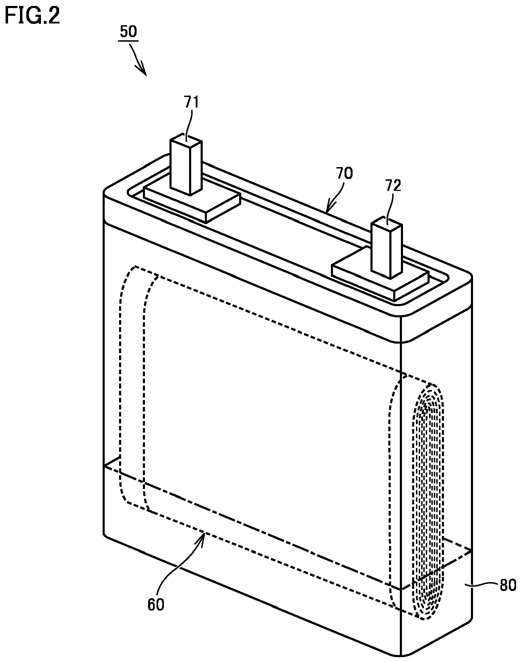

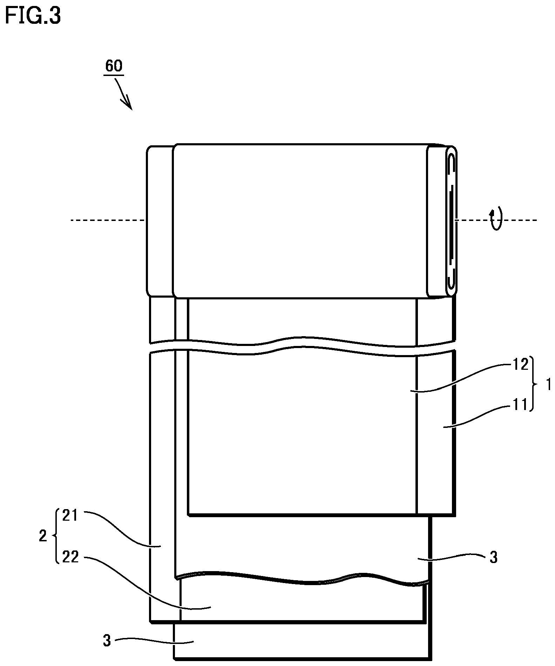

Battery 10 stores electric power for driving MG 95 and supplies the stored electric power to MG 95 through PCU 94. When MG 95 generates electric power, battery 10 is charged with the generated electric power received through PCU 94. Battery 10 is a battery assembly including one or more battery modules. Each of the one or more battery modules includes a plurality of cells 50. Each cell 50 is a lithium ion secondary battery in the present embodiment. The configuration of cell 50 will be described with reference to Figs. 2 and 3.

Monitoring unit 20 includes various sensors for monitoring the state of battery 10. Specifically, monitoring unit 20 includes a voltage sensor 201, a current sensor 202, and a temperature sensor 203. Voltage sensor 201 detects a voltage V of battery 10 (each cell). Current sensor 202 detects a current I supplied to and discharged from battery 10. Temperature sensor 203 detects a temperature T of battery 10. Each sensor outputs a signal indicating the detection result to battery ECU 40.

SMR 30 is electrically connected on a power line that connects battery 10 to PCU 94. SMR 30 is closed (on)/opened (off) in response to a control command from battery ECU 40. When SMR 30 is closed, battery 10 can be charged and discharged.

Battery ECU 40 includes a processor 401 and a memory 402. Processor 401 is an arithmetic processing unit such as a central processing unit (CPU) or a micro processing unit (MPU). Memory 402 is a storage device including a read only memory (ROM) and a random access memory (RAM). Memory 402 stores a system program including an operating system (OS), a control program including a computer-readable code, and various parameters for managing battery 10. Processor 401 reads the system program, the control program, and the parameters, deploys them in memory 402 for execution, and thereby implement various processes. In the present embodiment, the main process executed by processor 401 includes a process of estimating the state of charge (SOC) of battery 10 (each cell in the battery assembly). This process is also referred to as an "SOC estimation process" and will be described later in detail.

Inlet 91 is configured to be capable of connecting a charging connector (not shown) provided at the tip end of a charging cable through mechanical coupling. Connection between inlet 91 and the charging connector ensures an electrical connection between vehicle 900 and a charging facility (not shown).

Power conversion device 92 is, for example, an alternating-current (AC)/direct-current (DC) converter. Power conversion device 92 converts AC power supplied from the charging facility through the charging cable into DC power with which battery 10 is charged. Vehicle 900 may be configured to perform DC charging.

Charging relay 93 is electrically connected to a power line that connects SMR 30 and PCU 94. When charging relay 93 is closed and SMR 30 is closed, power transmission between inlet 91 and battery 10 is enabled.

PCU 94 is electrically connected between SMR 30 and MG 95. PCU 94 includes a converter and an inverter (each of which is not shown), and drives MG 95 in response to a command from integrated ECU 98.

MG 95 is an AC rotating electric machine and is, for example, a permanent magnet-type synchronous motor including a rotor having a permanent magnet embedded therein. The output torque of MG 95 is transmitted to driving wheel 97 through power transmission gear 96 to cause vehicle 900 to travel. Further, during a braking operation of vehicle 900, MG 95 generates electric power with rotational force of driving wheel 97. The electric power generated by MG 95 is converted by PCU 94 into charging power for battery 10.

Integrated ECU 98 includes a processor 981 and a memory 982. Processor 981 executes various control operations for controlling vehicle 900 to be brought into a desired state based on signals received from various sensors and also on programs and maps stored in memory 982. For example, integrated ECU 98 controls PCU 94 in cooperation with battery ECU 40 to thereby control charging and discharging of battery 10.

<Cell Configuration>

Fig. 2 is a perspective view schematically showing an example of the configuration of cell 50. Fig. 2 is a perspective view showing the inside of cell 50. Cell 50 is a sealed rectangular battery in the present example. Cell 50 may have a cylindrical shape. Cell 50 includes an electrode assembly 60, a battery case 70, and an electrolyte solution 80. Battery case 70 includes a positive electrode terminal 71 and a negative electrode terminal 72.

Electrode assembly 60 has, for example, a flat rectangular parallelepiped outer shape. Electrode assembly 60 is accommodated in battery case 70. Battery case 70 may be made of metal such as an aluminum (Al) alloy. Battery case 70 may be a pouch formed of an Al laminate film or the like. Electrolyte solution 80 is introduced into battery case 70 in which electrode assembly 60 is impregnated with electrolyte solution 80. The liquid level of electrolyte solution 80 is indicated by a dash-dotted line.

Fig. 3 is a diagram showing an example of the configuration of electrode assembly 60. Referring to Figs. 2 and 3, electrode assembly 60 is formed by winding a stack consisting of a positive electrode 1 and a negative electrode 2 alternately stacked with a separator 3 interposed therebetween. Fig. 3 shows an exploded view of the stack while being wound.

Positive electrode 1 has a sheet shape and includes a positive electrode current collector 11 and a positive electrode composite material layer 12. Positive electrode current collector 11 is electrically connected to positive electrode terminal 71.

Positive electrode current collector 11 may be, for example, an aluminum (Al) foil, an Al alloy foil, or the like.

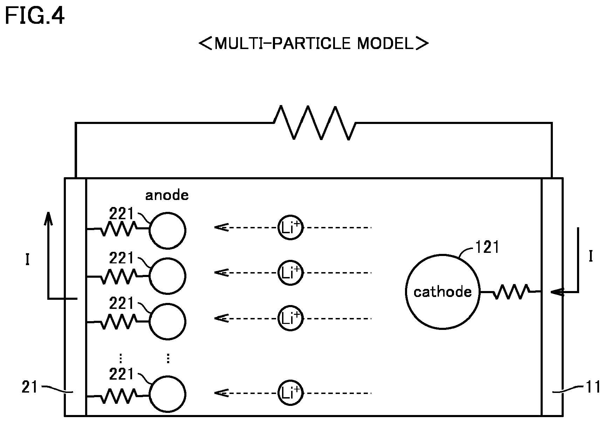

In the present example, positive electrode composite material layer 12 is formed on both the front surface and the back surface of positive electrode current collector 11. However, positive electrode composite material layer 12 may be formed only on the front surface (one of the surfaces) of positive electrode current collector 11. Positive electrode composite material layer 12 contains a positive electrode active material 121 (see Fig. 4), a conductive material (not shown), and a binder (not shown). Positive electrode active material 121 is, for example, $LiFePO_4$ (lithium iron phosphate, LFP). Positive electrode active material 121 may contain at least one selected from the group consisting of $LiCoO_2$, $LiNiO_2$, $LiMnO_2$, $LiMn_2O_4$, $Li(NiCoMn)O_2$, and $Li(NiCoAl)O_2$. The conductive material may contain, for example, at least one selected from the group consisting of carbon black (acetylene black and the like), vapor grown carbon fibers (VGCF), carbon nanotubes (CNT), and graphene flakes. The binder may contain, for example, at least one selected from the group consisting of carboxymethyl cellulose (CMC), styrene-butadiene rubber (SBR), polyvinylidene difluoride (PVdF), and polytetrafluoroethylene (PTFE).

Negative electrode 2 has a sheet shape and includes a negative electrode current collector 21 and a negative electrode composite material layer 22. Negative electrode current collector 21 is electrically connected to negative electrode terminal 72. Negative electrode current collector 21 may be, for example, a copper (Cu) foil.

In the present example, negative electrode composite material layer 22 is formed on both the front surface and the back surface of negative electrode current collector 21. However, negative electrode composite material layer 22 may be formed only on the front surface (one of the surfaces) of negative electrode current collector 21. Negative electrode composite material layer 22 contains a negative electrode active material 221 and a binder (not shown). Negative electrode active material 221 is, for example, a graphite-based material such as natural graphite, soft carbon, or hard carbon. The binder may contain, for example, at least one selected from the group consisting of styrene-butadiene rubber (SBR), acrylate-butadiene rubber (ABR), sodium alginate, carboxymethyl cellulose, polyacrylic acid, polyacrylonitrile (PAN), polyvinylidene difluoride (PVdF), polytetrafluoroethylene (PTFE), acrylic resin, methacrylic resin, polyvinylpyrrolidone (PVP), and polyvinyl alcohol (PVA).

Separator 3 is a strip-shaped film. Separator 3 is disposed between positive electrode 1 and negative electrode 2 to provide electrical insulation between positive electrode 1 and negative electrode 2. The material of separator 3 may be, for example, a porous film made of a polyolefin-based resin such as polyethylene (PE) or polypropylene (PP), a polyamide-based resin such as nylon and aromatic polyamide (aramid), or a woven fabric or a nonwoven fabric made of polypropylene, polyethylene terephthalate (PET), methyl cellulose, or the like.

Electrolyte solution 80 contains at least a lithium (Li) salt and a solvent. The Li salt is a supporting electrolyte dissolved in the solvent and may be, for example, $LiPF_6$. The solvent is aprotic. The solvent may be, for example, a mixture of cyclic carbonate and chain carbonate. Electrolyte solution 80 may further contain a known functional additive in addition to the Li salt and the solvent.

<Multi-Particle Model>

In the present embodiment, a multi-particle model (MPM) is adopted in order to estimate the SOC of battery 10 with high accuracy.

Fig. 4 is a conceptual diagram for illustrating a multi-particle model. In a mono-particle model, the positive electrode active material is schematically represented as one particle while the negative electrode active material is schematically represented as one particle. On the other hand, in the multi-particle model, it is assumed that the positive electrode and/or the negative electrode are/is formed of a large number of particles that are electronically and ionically connected to each other. In the multi-particle model in the present embodiment, negative electrode active material 221 is schematically represented as a multi-particle. Negative electrode composite material layer 22 contains a large number of negative electrode active material particles. Among these particles, the likelihood of occurrence of the charge transfer reaction (insertion/desorption reaction of lithium) varies depending on the parameters related to the structure of battery 10 (hereinafter referred to as a "structure parameter") and/or the parameters related to the material properties of battery 10 (hereinafter referred to as a "material property parameter"). The multi-particle model represents, by particles, a difference (distribution) of such a likelihood of occurrence of the charge transfer reaction. Positive electrode active material 121 is schematically represented as one particle in the present example, but may also be represented as a multi-particle.

Fig. 4 shows the state in which battery 10 is charged. When battery 10 is charged, lithium ions (denoted by $Li^+$) are desorbed from positive electrode active material 121 while lithium ions are inserted into respective negative electrode active materials 221. At this time, a current (a total current I described later) flows through battery 10. Although not shown, when battery 10 is discharged, the current flows in the direction opposite to the direction shown in Fig. 4.

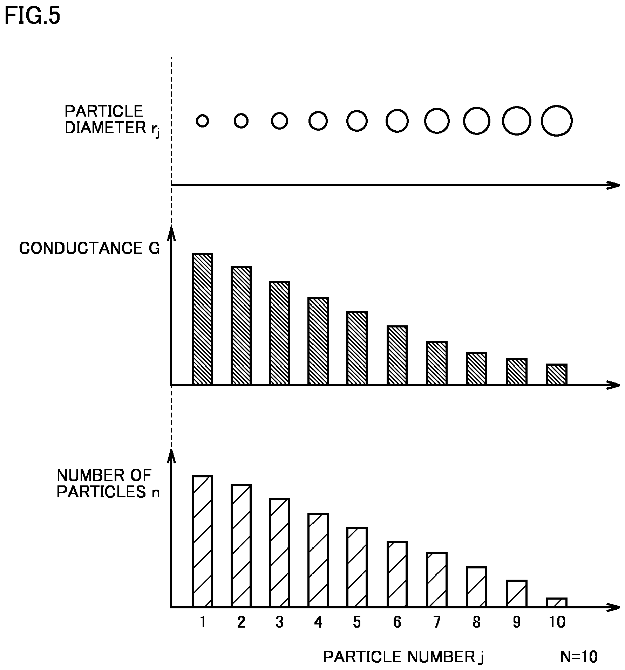

Fig. 5 is a conceptual diagram for illustrating a plurality of particles included in the multi-particle model. A symbol for distinguishing the types of particles from each other is defined as j. In this case, j = 1 to N. As N is larger, the amount of computation becomes larger. Thus, N may be determined based on the computation processing capability of battery ECU 40 (processor 401). In the present example, N = 10.

All particles of the multi-particle model are assumed to be spherical. The N types of particles have different particle diameters (radii). The particle diameter of a particle j (the j-th particle) is denoted by $r_j$. As j is smaller, particle diameter $r_j$ is smaller.

A particle surface area $S_j = 4\pi r_j$ corresponds to the reaction area of the negative electrode active material. A particle volume $V_j = (4\pi r_j^3)/3$ corresponds to the capacity of the negative electrode active material. Thus, particle surface area/volume = $S_j/V_j$ corresponds to the reaction area/capacity of the negative electrode active material. As particle diameter $r_j$ is smaller, the particle reaction area/capacity is larger, and therefore, the lithium amount (lithium concentration) in the particle tends to change. In other words, a current is more likely to flow as lithium ions are inserted/desorbed. Thus, the particle having a smaller particle diameter $r_j$ exhibits a lower resistance and a higher conductance (conductivity) $G_j$ that is an inverse of the resistance.

In this case, for ease of understanding, the description has been made with reference to an example of a situation in which conductance $G_j$ is determined by a particle diameter $r_j$ (the size of the collection of particles). The particle diameter is an example of the structure parameter. Other examples of the structure parameter include, for example, the distance between negative electrode active material 221 and negative electrode current collector 21 (hereinafter also referred to as a "distance between the current collecting tabs"), the thickness of negative electrode 2, the density of the particle of the negative electrode active material, the frequency distribution of the particle diameter of the negative electrode active material, the distribution of the conductive auxiliary agent contained in negative electrode 2, and the like. The material property parameters may be, for example, a specific resistivity of each of the materials of negative electrode 2 (negative electrode active material 221 and negative electrode current collector 21). These structure parameters and/or material property parameters also determine the likelihood of occurrence of the charge transfer reaction. Thus, conductance $G_j$ is determined based on at least one of the plurality of parameters included in the structure parameters and the material property parameters. It is desirable that the value of conductance $G_j$ is adaptively determined by applying various values to at least one of the parameters.

As described above, in the present embodiment, the number of particles j (also referred to as a frequency) considering the structure parameters such as particle diameter $r_j$ and the distance between current collecting tabs and/or the material property parameters is set as $n_j$. Theoretically, the distribution of the number of particles $n_j$ can be determined according to the specifications of electrode assembly 60 to be used (the specifications of the particle size distribution of the negative electrode active material, the shapes of negative electrode current collector 21 and negative electrode composite material layer 22, and the like). However, since it is complicated to obtain the distribution of the number of particles $n_j$ from the actual electrode assembly 60, the distribution of the number of particles $n_j$ may also be adaptively determined in practice. In the present example, as the particle number is smaller, the number of particles $n_j$ is larger. Setting the number of particles $n_j$ for each particle number corresponds to giving different weighting to each particle in accordance with the structure parameter and/or the material property parameter (see the averaging process in S107 described later).

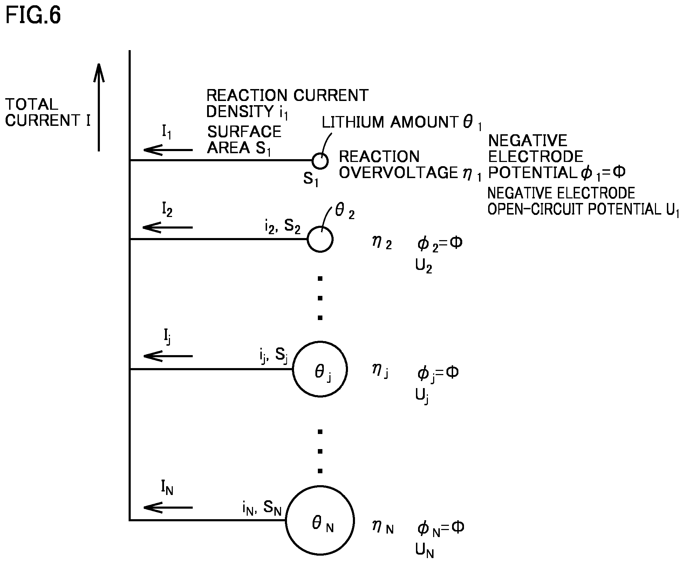

Fig. 6 is a diagram for illustrating an outline of the relation between parameters in the multi-particle model. According to the multi-particle model, the current flowing through each particle is determined in accordance with a reaction overvoltage $\eta_j$ of the corresponding particle. Reaction overvoltage $\eta_j$ is also referred to as an activation overvoltage and is an overvoltage related to the charge transfer reaction. Reaction overvoltage $\eta_j$ of particle j is determined by a negative electrode potential $\Phi$ and a negative electrode open-circuit potential $U_j$. The negative electrode potentials (closed-circuit potentials) of all the particles are equal to each other ($\phi_1 = \phi_2 = ...= \Phi$). On the other hand, negative electrode open-circuit potential $U_j$ depends on a lithium amount $\theta_j$ contained in a particle, and thus, may be different for each particle.

Lithium amount $\theta_j$ of particle j is defined as in the equation (1). Further, $c_j$ represents a lithium concentration on the surface of particle j (i.e., the surface of the negative electrode active material) and is a variable value that changes as the target cell is charged and discharged. On the other hand, $c_{max}$ is the highest lithium concentration (the critical lithium concentration) on the surface of the negative electrode active material and is a fixed value. Accordingly, lithium amount $\theta_j$ is a value within a range from 0 to 1.

[Equation 1]

$$\theta_j = \frac{c_j}{c_{max}} \quad \cdots (1)$$

Current $I_j$ flowing through particle j is calculated from a reaction current density $i_j$ and a surface area $S_j$ of this particle. The sum of currents $I_j$ for all of the particles shows a total current I flowing through a target cell.

<Process Flow>

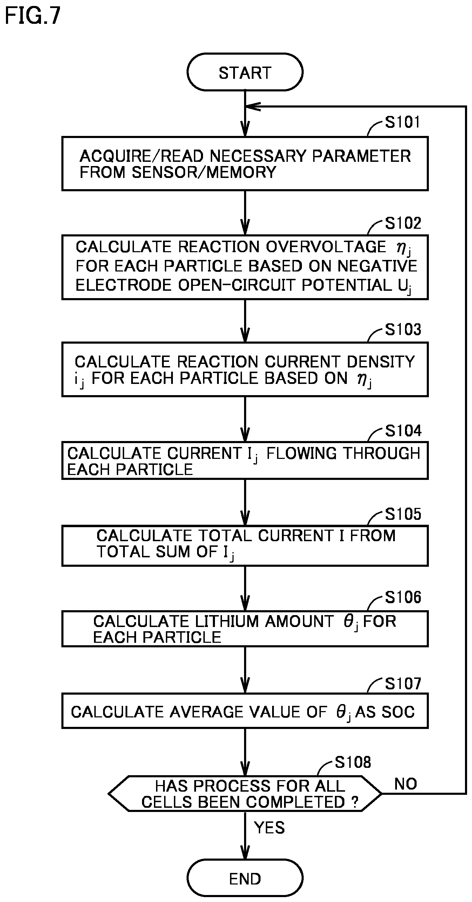

Fig. 7 is a flowchart illustrating a processing procedure of an SOC estimation process in the present embodiment. The process shown in this flowchart is executed when a predetermined condition is satisfied (for example, for each predetermined cycle). Each step is implemented by software processing by battery ECU 40 (processor 401), but may be implemented by hardware (an electric circuit) disposed inside battery ECU 40.

In the present example, the SOC estimation process is executed for each cell. A cell to be subjected to the SOC estimation process is referred to as a "target cell". The SOC estimation process is repeatedly executed. The value in the current SOC estimation process (the present value) is denoted by a reference symbol suffixed with (t), and the value in the previous SOC estimation process (the previous value) is denoted by a reference symbol suffixed with (t-1). The step is abbreviated as S.

In S101, battery ECU 40 acquires various variables (parameters) used in the current SOC estimation process from the sensor or reads these various variables from memory 402.

In S102, battery ECU 40 calculates, for each particle, reaction overvoltage $\eta_j$ by subtracting negative electrode open-circuit potential (negative electrode OCP) $U_j$ from negative electrode potential $\Phi$ (see the equation (2)).

[Equation 2]

$$\eta_j(t) = \Phi - U_j(t) = \Phi - U(\theta_j(t-1)) \quad \cdots (2)$$

Negative electrode potential $\Phi$ is calculated, for example, by adding an average value of overvoltages $\eta_j(t-1)$ of all the particles in the previous SOC estimation process to a predetermined equilibrium potential (a fixed value) of the negative electrode. When a reference electrode (not shown) is provided in cell 50, negative electrode potential $\Phi$ may be a negative electrode potential (a measured value) based on the potential of the reference electrode.

Negative electrode OCP, i.e., $U_j$, is calculated using a curve representing a correspondence relation between the lithium amount and negative electrode OCP (a lithium amount-negative electrode OCP curve). The lithium amount-negative electrode OCP curve is prepared in advance and stored in memory 402.

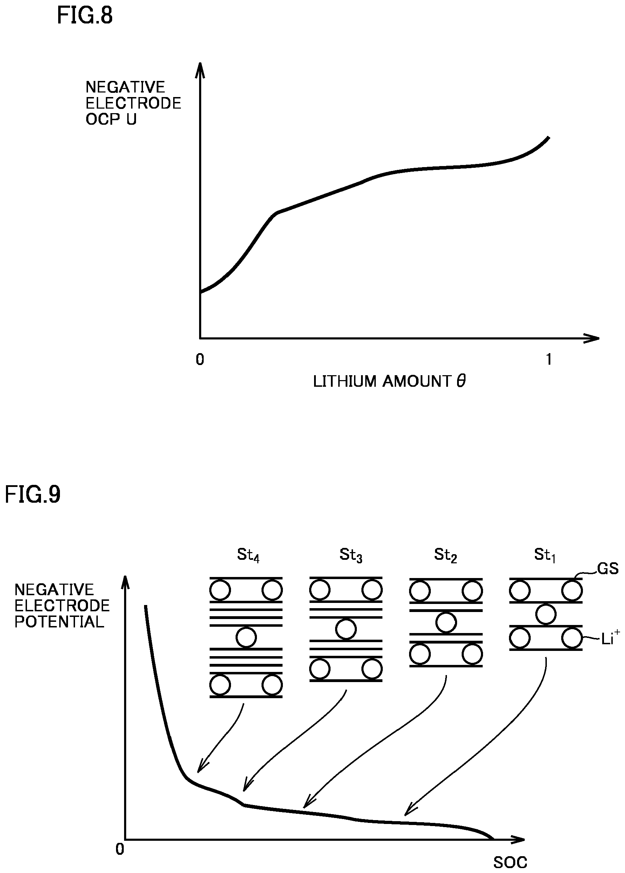

Fig. 8 is a diagram showing an example of the lithium amount-negative electrode OCP curve. The horizontal axis represents a lithium amount $\theta$ while the vertical axis represents a negative electrode OCP(U). Such a curve is prepared by experiments and stored in the form of a map or a table in memory 402 of battery ECU 40. Battery ECU 40 refers to the curve to calculate $U_j$ from lithium amount $\theta$. More specifically, battery ECU 40 calculates, as $U_j(t)$, negative electrode OCP corresponding to a lithium amount $(\theta_j(t) + \Delta\theta_j(t))$ in the curve. This lithium amount is a value calculated by the previous SOC estimation process.

Referring again to Fig. 7, in S 103, battery ECU 40 calculates, for each particle, reaction current density $i_j$ based on reaction overvoltage $\eta_j$ calculated in S102. Reaction current density $i_j$ is calculated, for example, according to the following Butler-Volmer equation (3). $G_j$ is a conductance described with reference to Fig. 5 and is a fixed value determined in advance by simulations or experiments. F is a Faraday constant. R is a gas constant. T is a temperature measured by a temperature sensor.

[Equation 3]

$$i_j(t) = G_j \left[ \exp\left(\frac{0.5F}{RT} \eta_j(t)\right) - \exp\left(\frac{-0.5F}{RT} \eta_j(t)\right) \right] \quad \cdots (3)$$

In S104, battery ECU 40 calculates a current $I_j(t)$ flowing through particle j for each particle. Reaction current $I_j(t)$ flowing through particle j is obtained by multiplying reaction current density $i_j$ by surface area $S_j$ (see the equation (4)).
[Equation 4]

$$I_j(t) = S_j \cdot i_j(t) \quad \cdots (4)$$

In S105, battery ECU 40 calculates total current I flowing through the target cell by calculating the total sum of currents $I_j$ flowing through the respective particles (see the equation (5)). The process in S105 may be omitted.
[Equation 5]

$$I(t) = \sum_{j=1}^{N} I_j(t) \quad \cdots (5)$$

In S106, battery ECU 40 calculates, for each particle, the lithium amount in consideration of the solid-phase diffusion of lithium ions (diffusion between the surface and the inside of the particle). In general, the negative electrode OCP is determined according to the lithium concentration on the particle surface of the negative electrode active material and the lithium concentration of the electrolyte solution. Thus, in the present embodiment, the negative electrode OCP can be faithfully reproduced by considering the change over time in the lithium amount on the particle surface resulting from the solid-phase diffusion of lithium ions.

A lithium amount $\theta_j(t)$ of particle j in the current SOC process is represented, for example, using the recurrence formula shown in the equation (6). In this case, $\Delta\theta_j(t)$ in the second term on the right side is a component representing a change in the lithium amount resulting from solid-phase diffusion.
[Equation 6]

$$\theta_j(t) = \theta_j(t-1) + \Delta\theta_j(t) \quad \cdots (6)$$

More specifically, a solid-phase diffusion component $\Delta\theta_j(t)$ shows the behavior of the first-order lag having a fixed time constant. The time constant depends, for example, on the diffusion rate of lithium ions in the electrochemical reaction. Specifically, solid-phase diffusion component $\Delta\theta_j(t)$ is calculated, for example, according to the equation (7).
[Equation 7]

$$\Delta\theta_j(t) = (1-\alpha) \cdot \Delta\theta_j(t-1) + \beta \cdot I_j(t) \quad \cdots (7)$$

In this case, $\alpha$ is a forgetting coefficient set at a value from 0 to 1. As $\alpha$ becomes larger, $(1-\alpha)$ becomes smaller, and the first term on the right side indicating the influence of a solid-phase diffusion component $\Delta\theta_j(t-1)$ exerted by the previous SOC estimation process becomes smaller. Further, $\beta$ is a coefficient used for causing the influence of the solid-phase diffusion of lithium ions to be reflected in the lithium amount. As $\beta$ becomes larger, the influence of the solid-phase diffusion of lithium ions becomes larger. In this case, $\alpha$ and $\beta$ are adaptively determined by experiments or simulations conducted in advance. The lithium amount calculated in S106 is used in the subsequent S107 and also used in the next SOC estimation process (the process in S102).

As disclosed in Japanese Patent Laying-Open No. 2008-243373, the diffusion of lithium ions between adjacent layers among a plurality of layers obtained by dividing each particle may be represented by solving the diffusion equation. On the other hand, according to the equations (6) and (7), since the solid-phase diffusion of lithium ions is represented by a more simplified method, the computation load of battery ECU 40 can be reduced.

In S107, battery ECU 40 calculates an average value of lithium amounts $\theta_j$ of all the particles as the SOC of the target cell (see the equation (8)). When calculating the average value, the number of particles $n_j$ for each particle number is also naturally taken into consideration.

[Equation 8]

$$SOC(t) = \mathrm{Ave}(\theta_j(t)) \quad \cdots (8)$$

In the multi-particle model in the present embodiment, for example, the particle having a smaller particle diameter $r_j$ or located closer to negative electrode current collector 21 exhibits higher conductance $G_j$ and contains lithium amount $\theta_j$ that is more likely to change, as described above. The distribution of lithium amount $\theta_j$ reflects how much lithium ions have moved in each particle in accordance with the difference in likelihood of occurrence of the charge transfer reaction. The average value of lithium amounts $\theta_j$ is a parameter representing the status of movement of the lithium ions in the entire target cell and can be regarded as corresponding to the SOC of the target cell.

In S108, battery ECU 40 determines whether or not the SOC estimation for all of the cells has been completed. When there remains a cell for which the SOC has not been estimated (NO in S 108), battery ECU 40 returns the process to S 101 and executes the process in S101 to S107 for the next cell. When the SOC estimation for all of the cells has been completed (YES in S108), battery ECU 40 ends the process.

<Stage Structure of Graphite>

As described above, a graphite-based negative electrode active material is used in battery 10. Graphite crystals in the negative electrode active material are formed by stacking graphene sheets (GS). Lithium ions are inserted (occluded) into gaps between the graphene sheets. Regarding insertion of lithium ions, it is known that graphite has a stage structure.

Fig. 9 is a diagram for illustrating the stage structure of graphite. The horizontal axis represents an SOC while the vertical axis represents a potential. Graphite has four types of stage structures in accordance with the amount of the inserted lithium ions (i.e., an SOC). The n-th stage structure (n = 1 to 4) indicates the structure occurring when there are (n-1) layers in which lithium ions are not inserted between two layers between which lithium ions are inserted. As the amount of the inserted lithium ions increases, the stage structure transitions in order of the fourth stage structure ($St_4$), the third stage structure ($St_3$), the second stage structure ($St_2$), and the first stage structure (Sti). Such a stage structure of graphite can be reflected in the shape of the "OCV curve" that represents the correspondence relation between the SOC and the OCV of battery 10.

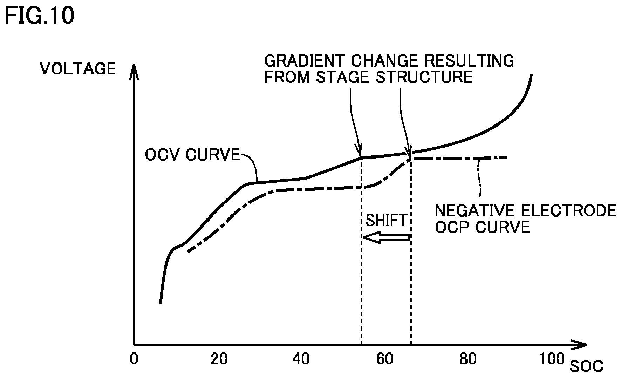

Fig. 10 is a diagram showing an example of the OCV curve. The horizontal axis represents an SOC while the vertical axis represents a voltage (a potential). In Fig. 10, a solid line indicates an OCV curve and, for comparison, a dash-dotted line indicates a negative OCP curve inverted and offset in the up-down direction.

In the actual battery, the gradient (the rate of change) of the negative OCP curve differs between successive stages. This gradient change appears as a "step" in the OCV curve. The position and the size of the step may be different depending on the SOC at the start of charging or discharging of the battery (a start SOC) and the magnitude of the current flowing through the battery (a current rate). More specifically, as the start SOC is lower, the positional deviation (a shift toward the low SOC side in the example in Fig. 10) of the step becomes larger. Further, as the current rate is smaller, the size of the step (the steepness of the gradient change) becomes larger.

When the positive electrode active material is lithium iron phosphate (LFP) or the like, the OCV curve has a wide flat region (a region in which the OCV change resulting from the SOC change is minute). Thus, the characteristics of the shape of the negative electrode OCP curve resulting from graphite in the negative electrode active material is significantly reflected in the OCV curve, and the problem of the above-mentioned step may become particularly significant.

In a mono-particle model that is a conventional battery model, it is difficult to reproduce the OCV curve, more specifically, the above-described "step", occurring when a graphite-based negative electrode active material is used. In particular, it is impossible to reproduce the difference in position and size between the steps resulting from the difference between the start SOC and the charging rate. Thus, there is still room for improvement in the accuracy of the SOC estimation.

On the other hand, in the present embodiment, a multi-particle model applied to the negative electrode active material includes a plurality of particles, specifically, among which at least one of the structure parameter and the material property parameter is different. Thereby, for example, the difference in reaction area and capacity between the stage structures of graphite can be reflected in the OCV curve to reproduce the size of each step. As a result, the accuracy in estimating the SOC of battery 10 can be improved. In addition, by considering solid-phase diffusion (see the equations (6) and (7)), the positional deviation of the step (the shift in the SOC direction) can also be reproduced. Therefore, the accuracy in estimating the SOC of battery 10 can be further improved.

Further, in the present embodiment, it is assumed that there are a plurality of particles having the same structure parameter and/or the same material property parameter. Setting the number of particles $n_j$ for each particle as described with reference to Fig. 5 corresponds to setting weighting for each structure parameter and/or each material property parameter. Thereby, the types of particles are reduced as compared with the case where all of the particles are assumed to have different structure parameters and different material property parameters. As a result, the computation load of battery ECU 40 can be reduced.

Although the embodiments of the present disclosure have been described as above, it should be understood that the embodiments disclosed herein are illustrative and non-restrictive in every respect. The scope of the present disclosure is defined by the scope of the claims and is intended to include any modifications within the meaning and scope equivalent to the scope of the claims.

**Claims**

1. A method of managing a lithium ion secondary battery (10) including a negative electrode (2), the negative electrode (2) containing a negative electrode active material (221) based on graphite and a negative electrode current collector (21), the method comprising:

   estimating, by a processor (401), an SOC of the lithium ion secondary battery (10) using a battery model for estimating an internal state of the lithium ion secondary battery (10), wherein
   the battery model is a multi-particle model representing the negative electrode active material by a plurality of types of particles, each of the plurality of types of particles represents a likelihood of occurrence of a charge transfer reaction of lithium ions, and at least one of a structure parameter and a material property parameter is different among the plurality of types of particles,
   the structure parameter includes at least one of

   a particle diameter of the negative electrode active material (221),
   a distance between the negative electrode active material (221) and the negative electrode current collector (21),
   a thickness of the negative electrode (2),
   a density of a particle of the negative electrode active material (221),
   a frequency distribution of the particle diameter of the negative electrode active material (221), and
   a distribution of a conductive auxiliary agent contained in the negative electrode (2),

   the material property parameter includes a resistivity of a material of each of the negative electrode active material (221) and the negative electrode current collector (21), and
   the estimating the SOC includes

   calculating, for each of target particles among the plurality of types of particles, a reaction overvoltage ($\eta_j$) based on a previous value of a lithium amount ($\theta_j$) contained in each of the target particles,
   calculating, for each of the target particles, a reaction current density ($i_j$) of each of the target particles based on the reaction overvoltage ($\eta_j$),
   calculating, for each of the target particles, a present value of the lithium amount ($\theta_j$) based on the reaction current density ($i_j$), and
   calculating an average value of the present value of the lithium amount ($\theta_j$) in each of the plurality of types of particles as the SOC of the lithium ion secondary battery (10).

2. The method according to claim 1, wherein the calculating the lithium amount ($\theta_j$) includes, calculating, for each of the target particles, a change over time ($\Delta\theta_j$) in the lithium amount resulting from solid-phase diffusion of the lithium ions.

3. The method according to claim 2, wherein the solid-phase diffusion is represented by a relational expression indicating a behavior of a first-order lag and having a time constant ($\alpha, \beta$) corresponding to a diffusion rate of the lithium ions.

4. The method according to any one of claims 1 to 3, wherein the particles are reduced to be smaller in number by setting weighting for each the structure parameter or each the material property parameter represented by each of the target particles, than when the weighting is not set.

**5.** The method according to any one of claims 1 to 4, wherein

the lithium ion secondary battery (10) includes a positive electrode (1) containing a positive electrode active material (121), and
a flat region of the positive electrode active material (121) is wide, the flat region being a region in which a potential change resulting from an SOC change is minute.

**6.** The method according to claim 5, wherein the positive electrode active material (121) contains lithium iron phosphate.

**7.** A battery management system (100) comprising the processor (401) according to any one of claims 1 to 6.

# FIG.1

900

FIG.2

FIG.3

FIG.4

<MULTI-PARTICLE MODEL>

FIG.5

PARTICLE DIAMETER $r_j$

CONDUCTANCE G

NUMBER OF PARTICLES n

PARTICLE NUMBER $j$          N=10

FIG.6

TOTAL
CURRENT I

$I_1$ REACTION CURRENT
DENSITY $i_1$
SURFACE
AREA $S_1$

LITHIUM AMOUNT $\theta_1$
REACTION
OVERVOLTAGE $\eta_1$

NEGATIVE
ELECTRODE
POTENTIAL $\phi_1 = \Phi$

NEGATIVE ELECTRODE
OPEN-CIRCUIT POTENTIAL $U_1$

$I_2$ $i_2$, $S_2$ $\theta_2$ $\eta_2$ $\phi_2 = \Phi$
$U_2$

$I_j$ $i_j$, $S_j$ $\theta_j$ $\eta_j$ $\phi_j = \Phi$
$U_j$

$I_N$ $i_N$, $S_N$ $\theta_N$ $\eta_N$ $\phi_N = \Phi$
$U_N$

## FIG.7

```
                    ┌─────────────┐
                    │    START    │
                    └─────────────┘
                           │
                           ▼                    ┌─S101
        ┌──────────────────────────────────────┐
        │ ACQUIRE/READ NECESSARY PARAMETER      │
        │ FROM SENSOR/MEMORY                    │
        └──────────────────────────────────────┘
                           │
                           ▼                    ┌─S102
        ┌──────────────────────────────────────┐
        │ CALCULATE REACTION OVERVOLTAGE ηⱼ     │
        │ FOR EACH PARTICLE BASED ON NEGATIVE   │
        │ ELECTRODE OPEN-CIRCUIT POTENTIAL Uⱼ   │
        └──────────────────────────────────────┘
                           │
                           ▼                    ┌─S103
        ┌──────────────────────────────────────┐
        │ CALCULATE REACTION CURRENT DENSITY    │
        │ iⱼ FOR EACH PARTICLE BASED ON ηⱼ      │
        └──────────────────────────────────────┘
                           │
                           ▼                    ┌─S104
        ┌──────────────────────────────────────┐
        │ CALCULATE CURRENT Iⱼ FLOWING THROUGH  │
        │ EACH PARTICLE                         │
        └──────────────────────────────────────┘
                           │
                           ▼                    ┌─S105
        ┌──────────────────────────────────────┐
        │ CALCULATE TOTAL CURRENT I FROM        │
        │ TOTAL SUM OF Iⱼ                       │
        └──────────────────────────────────────┘
                           │
                           ▼                    ┌─S106
        ┌──────────────────────────────────────┐
        │ CALCULATE LITHIUM AMOUNT θⱼ FOR       │
        │ EACH PARTICLE                         │
        └──────────────────────────────────────┘
                           │
                           ▼                    ┌─S107
        ┌──────────────────────────────────────┐
        │ CALCULATE AVERAGE VALUE OF θⱼ AS SOC  │
        └──────────────────────────────────────┘
                           │
                           ▼           ┌─S108
                    ◇─────────────────◇      NO
                    < HAS PROCESS FOR ALL >──────
                    < CELLS BEEN COMPLETED ? >
                    ◇─────────────────◇
                           │ YES
                           ▼
                    ┌─────────────┐
                    │     END     │
                    └─────────────┘
```

S101 — ACQUIRE/READ NECESSARY PARAMETER FROM SENSOR/MEMORY

S102 — CALCULATE REACTION OVERVOLTAGE $\eta_j$ FOR EACH PARTICLE BASED ON NEGATIVE ELECTRODE OPEN-CIRCUIT POTENTIAL $U_j$

S103 — CALCULATE REACTION CURRENT DENSITY $i_j$ FOR EACH PARTICLE BASED ON $\eta_j$

S104 — CALCULATE CURRENT $I_j$ FLOWING THROUGH EACH PARTICLE

S105 — CALCULATE TOTAL CURRENT I FROM TOTAL SUM OF $I_j$

S106 — CALCULATE LITHIUM AMOUNT $\theta_j$ FOR EACH PARTICLE

S107 — CALCULATE AVERAGE VALUE OF $\theta_j$ AS SOC

S108 — HAS PROCESS FOR ALL CELLS BEEN COMPLETED ?

FIG.8

FIG.9

## FIG.10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023097729 A

- JP 2008243373 A